# EUROPÄISCHE PATENTANMELDUNG

(11) **EP 2 045 921 A1**
(43) Veröffentlichungstag der Anmeldung: **08.04.2009**
(21) Anmeldenummer: 07117423.9
(22) Anmeldetag: 27.09.2007
(51) Int. Cl.: H03K 17/693

(54) **Schnittstelle zum Anschließen einer Wandlervorrichtung an eine zweipolige Leitung**

(71) Anmelder: Siemens Schweiz AG, 8047 Zürich (CH)
(72) Erfinder: Kästli, Urs Dr., 8708 Männedorf (CH)
(74) Vertreter: Maier, Daniel Oliver

(57) **Zusammenfassung**

Es wird eine Schnittstelle (130) zum Anschließen einer Wandlervorrichtung (160) an eine zweipolige Leitung beschrieben. Die Schnittstelle (130) weist auf drei Eingänge (X1,X2,X3), einen ersten Ausgang (A1), welcher mit einem ersten Eingang (X1) verbunden ist, und einen zweiten Ausgang (A2), welcher mit einem zweiten Eingang (X2) oder mit dem dritten Eingang (X3) verbindbar ist. Die Schnittstelle (130) umfasst ferner eine Schalteinrichtung (132), welche mit dem zweiten Eingang (X2), dem dritten Eingang (X3) und dem zweiten Ausgang (A2) verbunden ist, und eine Steuereinrichtung (134), welche mit dem dritten Eingang (X3) derart gekoppelt ist, dass von dem dritten Eingang (X3) an die Steuereinrichtung (132) ein Detektionssignal (DirSense) zuführbar ist. Dieses ist indikativ dafür, ob der zweite Eingang (X2) oder der dritte Eingang (X3) mit dem zweiten Pol der zweipoligen Leitung verbunden ist. Die Steuereinrichtung (134) ist derart eingerichtet, dass basierend auf dem Detektionssignal (DirSense) der zweite Eingang (X2) oder alternativ der dritte Eingang (X3) mit dem zweiten Ausgang (A2) verbunden wird.

## Beschreibung

Die vorliegende Erfindung betrifft das technische Gebiet der elektrischen bzw. der elektronischen Schaltungstechnik. Die vorliegende Erfindung betrifft insbesondere eine Schnittstelle zum Anschließen einer Wandlervorrichtung an eine zweipolige Leitung, wobei ein erster Pol ein höheres elektrisches Potential und der zweite Pol ein niedrigeres elektrisches Potential aufweist. Die vorliegende Erfindung betrifft ferner ein Wandlersystem sowie eine Wandleranlage, welche die genannte Schnittstelle zum Anschließen einer Wandlervorrichtung verwenden.

In Europa ist in der automatischen Brandmeldetechnik durch Normen und Installationsrichtlinien in vielen Anwendungen eine Absicherung einer Brandmeldelinie gegen vollständigen Ausfall durch Leitungskurzschluss erforderlich. Diese Anforderung wird heute entweder durch zusätzlich zu den eigentlichen Sensoren und Aktuatoren an bestimmten Stellen der Brandmeldelinie eingefügte Kurzschlusstrennelemente oder durch in jedem Sensor oder Aktuator integrierten Kurzschlussisolator und Ringleitungsaufbau sichergestellt. Ein Kurzschlussisolator ist beispielsweise in der EP 0 111 178 B1 beschrieben, welche eine Überwachungsanlage mit mehreren kettenförmig an einer ringförmigen Meldelinie liegenden Meldern offenbart, die an einer Zentrale mit einer Auswerteeinheit angeschlossen sind. Über den zeitlichen Verlauf einer Abfragespannung kann die Auswerteeinheit feststellen, wie der Betriebszustand der einzelnen Melder ist. Ferner kann ein Kurzschluss in der Meldelinie zwischen zwei benachbarten Meldern detektiert und lokalisiert werden. Durch eine selektive Abschaltung des Teils der Meldelinie, in dem der Kurzschluss aufgetreten ist, kann auf der restlichen Meldelinie die gesamte Arbeitspannung erhalten bleiben.

In außereuropäischen Märkten, insbesondere in den vereinigten Staaten von Amerika, ist ein Funktionserhalt der Melderleitung bei Kurzschlüssen oft nicht gefordert. Der Anschluss von häufig sehr vielen Sensor- und Aktuatoren an eine solche zweipolige Drahtleitung soll jedoch möglichst rationell und mit wenigen Fehlermöglichkeiten erfolgen können. Es ist daher von Vorteil, wenn die üblicherweise polarisierte Melderleitung ohne Beachtung der Polarität mit den Geräten verbunden werden kann. So ist beispielsweise in der US 6,738,238 B2 eine Feuermeldeanlage offenbart, welche eine Zentrale und eine Mehrzahl von Gefahrmeldegeräte aufweist. Die Gefahrmeldegeräte sind über eine Zweipunktleitung mit der Zentrale verbunden, wobei die Zweipunktleitung sowohl der Stromversorgung der einzelnen Gefahrmeldegeräte als auch einer Signalisierung verschiedener Betriebszustände der einzelnen Gefahrmeldegeräte von den Gefahrmeldegeräten hin zu der Zentrale dient. Die Kopplung eines Gefahrmeldegerätes mit der Zweipunktleitung erfolgt über jeweils ein Strom- und Signalinterface, welches unabhängig von der Polarität des jeweiligen Anschlusses arbeitet. Dadurch können die einzelnen Gefahrmeldegeräte polaritätsunabhängig betrieben werden. Die Strom-und Signalinterfaces weisen jeweils einen Gleichrichter auf, welcher eine nicht unerhebliche Anfälligkeit gegen Rauschen aufweist und so die Betriebssicherheit der Gefahrmeldegeräte nachteilig beeinflusst.

Der Erfindung liegt die Aufgabe zugrunde, die Anschlussmöglichkeiten für eine Wandlervorrichtung an eine zweipolige Drahtleitung in Hinblick auf die Sicherheitsbestimmungen in Europa und außerhalb von Europa zu verbessern.

Diese Aufgabe wird gelöst durch den Gegenstand des unabhängigen Patentanspruchs. Vorteilhafte Ausführungsformen der vorliegenden Erfindung sind in den abhängigen Ansprüchen beschrieben.

Gemäß einem ersten Aspekt der Erfindung wird eine Schnittstelle zum Anschließen einer Wandlervorrichtung an eine zweipolige Leitung beschrieben, wobei ein erster Pol der Leitung ein höheres elektrisches Potential und der zweite Pol der Leitung ein niedrigeres elektrisches Potential aufweist. Die beschrieben Schnittstelle weist auf (a) einen ersten Eingang, (b) einen zweiten Eingang, (c) einen dritten Eingang, (d) einen ersten Ausgang, welcher mit dem ersten Eingang verbunden ist, und (e) einen zweiten Ausgang, welcher mit dem zweiten Eingang oder mit dem dritten Eingang verbindbar ist. Die beschriebene Schnittstelle weist ferner auf (f) eine Schalteinrichtung, welche mit dem zweiten Eingang, mit dem dritten Eingang und mit dem zweiten Ausgang verbunden ist, und (g) eine Steuereinrichtung, welche mit dem dritten Eingang derart gekoppelt ist, dass von dem dritten Eingang an die Steuereinrichtung ein Detektionssignal zuführbar ist, welches indikativ ist, ob der zweite Eingang oder ob der dritte Eingang mit dem zweiten Pol der zweipoligen Leitung verbunden ist, und welche mit der Schalteinrichtung verbunden ist. Die Steuereinrichtung ist derart eingerichtet, dass basierend auf dem Detektionssignal der zweite Eingang oder alternativ der dritte Eingang mit dem zweiten Ausgang verbunden wird.

Der Erfindung liegt die Erkenntnis zugrunde, dass bei Verwendung der beschriebenen Schnittstelle zum Anschließen einer Wandlervorrichtung Fehler hinsichtlich der Polarität des Anschlusses auf effektive Weise vermieden werden können. Die erfindungsgemäße Schnittstelle erkennt nämlich von selbst, ob der zweite Eingang oder der dritte Eingang mit dem zweiten Pol, d.h. mit dem Pol mit dem niedrigeren elektrischen Potential, der zweipoligen Leitung verbunden ist. Durch die Steuereinrichtung wird die Schalteinrichtung in einen Zustand gebracht, so dass der negativere Pol der zweipoligen Leitung mit dem zweiten Ausgang verbunden wird. An diesen Ausgang kann dann ein negativer Anschluss der Wandlervorrichtung angeschlossen werden.

Durch die Verwendung von drei Eingängen, von denen jedoch lediglich zwei zur Stromversorgung der Schnittstelle und/oder einer daran angeschlossenen Wandlervorrichtung benutzt werden, ergeben sich zwei unterschiedliche Anschlussmöglichkeiten, die auf elegante Weise an die Sicherheitsbestimmung in Europa und außerhalb von Europa geltende Sicherheitsbestimmungen angepasst sind.

Falls der erste Pol der zweipoligen Leitung mit dem ersten Eingang der erfindungsgemäßen Schnittstelle verbunden ist, dann liegt das höhere Potential der zweipoligen Leitung infolge der direkten Verbindung zwischen dem ersten Eingang und dem ersten Ausgang unmittelbar an dem ersten Ausgang an. An diesen kann dann ein positiver Anschluss der Wandlervorrichtung angeschlossen werden.

Es wird darauf hingewiesen, dass, sofern nichts Gegenteiligen angegeben, im Rahmen dieser Anmeldung unter dem Begriff "Verbinden" stets ein "elektrisches Verbinden" zu verstehen ist. Eine elektrische Verbindung kann dabei neben einer direkten Drahtverbindung auch über einen an die jeweilige Signalstromstärke angepassten Widerstand oder durch eine in Durchlassrichtung geschaltete Diode erfolgen.

Die Wandlervorrichtung kann prinzipiell jedes Gerät sein, welche eine Eingangsgröße in eine Ausgangsgröße umwandelt. Im Bereich der Gefahrmeldetechnik kann die Wandlervorrichtung eine Meldeeinrichtung wie beispielsweise ein Sensor, eine optische und/oder akustische Evakuiersteuerung bzw. Evakuierhilfe, eine optische und/oder eine akustische Anzeigeeinrichtung sein oder jedes andere Gerät sein, welches in einem Gefahrfall Personen beim Verlassen des Gefahrenbereichs unterstützt. Als Sensoren kommen beispielsweise Brand-, Rauch-, Temperatur-, Geruchs- und/oder chemische Detektoren in Betracht, welche abhängig von der jeweiligen Gefährdung eine Gefahrensituation erkennen können.

Die Wandlervorrichtung kann jedoch auch ein Aktuator sein, welche beispielsweise in einem Gefahrfall eine Tür öffnet oder schließt.

Es wird darauf hingewiesen, dass sich die Begriffe "höher" bzw. "positiver" und "niedriger" bzw. "negativer" jeweils auf die tatsächlich anliegenden elektrischen Potentiale und nicht auf die Beträge der Potentiale beziehen. Selbstverständlich kann eines der Potentiale gleichzeitig auch die Erdung für die Wandlervorrichtung sein. Bevorzugt wird dafür das negativere Potential verwendet, welches erfindungsgemäß an dem zweiten Ausgang der Schnittstelle anliegt.

Es wird ferner darauf hingewesen, dass die beschriebene Schnittstelle auch mit umgekehrter Polarität betrieben werden kann. In diesem Fall weist dann der erste Pol der zweipoligen Leitung ein niedrigeres elektrisches Potential auf, wohingegen der zweite Pol der zweipoligen Leitung ein höheres elektrisches Potential aufweist.

Die zweipolige Leitung kann eine herkömmliche Drahtleitung sein, welche in bekannter Weise sowohl für eine Versorgung der Wandlervorrichtung mit elektrischer Energie als auch für eine Signalweiterleitung eines Messsignals vorgesehen ist. Dabei kann das Messsignal beispielsweise Informationen über einen Messwert und/oder über einen Betriebszustand der Wandlervorrichtung an eine Zentrale enthalten.

Gemäß einem Ausführungsbeispiel der Erfindung weist die Schnittstelle zusätzlich auf (a) ein erstes Gleichrichterelement, welches zwischen dem dritten Eingang und dem ersten Ausgang geschaltet ist, und (b) ein zweites Gleichrichterelement, welches zwischen dem zweiten Eingang und dem ersten Ausgang geschaltet ist. Dabei sind die beiden Gleichrichterelemente derart orientiert, dass von dem zweiten Eingang und dem dritten Eingang derjenige Eingang, welcher mit dem ersten Pol der zweipoligen Leitung verbunden ist, mit dem ersten Ausgang verbunden ist.

Dies bedeutet, dass für den Fall, dass nicht der erste Eingang sondern entweder der zweite oder der dritte Eingang mit dem positiven Pol der zweipoligen Leitung verbunden ist, dieser positive Anschluss automatisch mit dem ersten Ausgang verbunden wird.

Die Gleichrichterelemente können beispielsweise einfache Dioden sein, welche lediglich einen Stromfluss in einer Richtung zulassen.

Es wird darauf hingewiesen, dass auch die Schalteinrichtung eine oder mehrere Dioden aufweisen kann. Diese Dioden können auch parasitäre bzw. inhärente Dioden von Transistoren sein, die als Schaltelemente innerhalb der Schalteinrichtung eingesetzt werden. Auch diese inhärenten Dioden können zu einer passiven Gleichrichtung betragen, so dass stets der erste Ausgang mit dem positiven Pol der zweipoligen Leitung verbunden ist. In entsprechender Weise wird stets der der zweite Ausgang mit dem negativen Pol der zweipoligen Leitung verbunden.

Gemäß einem weiteren Ausführungsbeispiel der Erfindung weist die Schalteinrichtung auf (a) ein erstes Schaltelement, welches zwischen dem dritten Eingang und dem zweiten Ausgang angeordnet ist, und (b) ein zweites Schaltelement, welches zwischen dem zweiten Eingang und dem zweiten Ausgang angeordnet ist.

Die beiden Schaltelemente können Transistoren, insbesondere Feldeffekt-Transistoren sein. Durch eine geeignete Ansteuerung dieser Transistoren durch die Steuereinrichtung kann somit derjenige Eingang, welcher mit dem zweiten Pol der zweipoligen Leitung verbunden ist, auf einfache Weise mit dem zweiten Ausgang verbunden werden.

Gemäß einem weiteren Ausführungsbeispiel der Erfindung sind die beiden Schaltelemente unabhängig voneinander von der Steuereinrichtung ansteuerbar. Dies bedeutet, dass die Steuereinrichtung die Schalteinrichtung auch in einen Zustand versetzen kann, in dem beide Schaltelemente geschlossen sind. Damit kann zwischen dem zweiten Eingang und dem dritten Eingang eine niederohmige elektrische Verbindung hergestellt werden. Der effektive elektrische Widerstand über die beiden Schaltelemente kann dabei kleiner als der Eingangswiderstand einer an die Ausgänge der Schnittstelle angeschlossenen Wandlervorrichtung sein.

Eine im Vergleich zu dem Eingangswiderstand der Wandlervorrichtung niederohmige Verbindung zwischen dem zweiten Eingang und dem dritten Eingang kann dazu genutzt werden, dass für den Fall, dass mehrere Schnittstellen mit entsprechenden Wandlervorrichtungen über die zweipolige Leitung an eine Zentrale angeschlossen sind, eine weitere Schnittstellen von der Zentrale adressiert werden kann, welche in bekannter Weise über die zweipolige Leitung Informationen über ihren Betriebszustand an die Zentrale mitteilen kann. Somit können bei einer sequentiellen Weiterschaltung, welches durch ein Schließen bzw. durch ein Durchschalten von beiden Transistoren erfolgt, nacheinander sämtliche an die zweipolige Leitung angeschlossenen Schnittstellen bzw. Wandlervorrichtung von der Zentrale abgefragt werden.

Die Steuereinrichtung kann die beiden Schaltelemente auch so ansteuern, dass beide Schaltelemente offen sind, so dass weder der zweite Eingang noch der dritte Eingang mit dem zweiten Ausgang verbunden ist. Dies bedeutet, dass die an die beschriebene Schnittstelle angeschlossene Wandlervorrichtung und ggf. weitere der Schnittstelle über die zweipolige Leitung nachgeschaltete Schnittstellen bzw. Wandlervorrichtungen von dem negativen Pol der zweipoligen Leitung abgetrennt werden. Dies kann auf vorteilhafte Weise dann genutzt werden, wenn sich ausgehend von einer Zentrale nach einer bestimmten Schnittstelle in der zweipoligen Leitung ein Kurzschluss gebildet hat. Durch die beschriebene Trennfunktion der Schnittstelle kann auf einfache Weise der entsprechende Abschnitt der zweipoligen Leitung abgetrennt und somit der Betrieb von Wandlervorrichtungen, die zwischen dem kurzschlussbehafteten Leitungsstück und der Zentrale angeordnet sind, aufrecht erhalten werden.

Im Falle einer von der Zentrale ausgehenden Ringleitung können somit bei lediglich einem Kurzschluss sämtliche Wandlervorrichtungen weiter betrieben werden. Dabei werden die Wandlervorrichtungen auf der einen Seite der Ringleitung über den einen Zweig der getrennten Ringleitung und die Wandlervorrichtungen auf der anderen Seite der Ringleitung über den anderen Zweig der getrennten Ringleitung versorgt.

Gemäß einem weiteren Ausführungsbeispiel der Erfindung weist die Schnittstelle zusätzlich eine Überspannungsschutzeinrichtung auf, welche zwischen dem ersten Ausgang und dem zweiten Ausgang geschaltet ist.

Die Überspannungsschutzeinrichtung kann beispielsweise eine einfache Zenerdiode sein. Diese kann, ggf. im Zusammenwirken mit der Schalteinrichtung und/oder mit den oben beschriebenen Gleichrichterelementen, die Elektronik der Wandlervorrichtung und/oder die Steuereinrichtung der beschriebnen Schnittstelle auf effektive Weise vor transienten Überspannung auf der zweipoligen Leitung schützen, welche beispielsweise durch eine kapazitive oder induktive Kopplung eingespeist werden.

Gemäß einem weiteren Ausführungsbeispiel der Erfindung weist die Schnittstelle zusätzlich einen ersten Widerstand zum Abgreifen des Detektionssignals auf.

Der erste Widerstand kann dabei zwischen dem dritten Eingang und der Steuereinrichtung angeordnet sein. Der erste Widerstand ist hinsichtlich seines Widerstandswertes bevorzugt so dimensioniert, dass unabhängig von der Beschaltung der drei Eingänge der Stromfluss hin zu der Steuereinrichtung so gering ist, dass die Steuereinrichtung vor Beschädigungen geschützt ist.

Die Verwendung eines geeignet dimensionierten ersten Widerstandes zum Abgreifen des Detektionssignals bzw. der Detektionsspannung hat den Vorteil, dass anhand des Vorzeichens der Detektionsspannung die Polarität der an dem dritten Eingang angelegten Versorgungsspannung unmittelbar erfasst wird.

Gemäß einem weiteren Ausführungsbeispiel der Erfindung weist die Schnittstelle zusätzlich einen zweiten Widerstand auf, welcher zwischen dem ersten Eingang und dem zweiten Eingang geschalten ist. Dies hat den Vorteil, dass für den Fall, bei dem der zweite Eingang nicht an die zweipolige Leitung angeschlossen ist, das Detektionssignal hinsichtlich seiner Polarität das gleiche Vorzeichen aufweist, welches auch die an dem ersten Eingang anliegende Versorgungsspannung aufweist. Somit kann unabhängig von der Belegung der drei Eingänge mit den beiden Polen der zweipoligen Leitung stets ein polaritätsrichtiger Anschluss der Wandlervorrichtung über die beschriebene Schnittstelle gewährleistet werden. Dabei kann die Steuereinrichtung im Wesentlichen die Funktion einer Logikeinheit aufweisen, welche abhängig von der Polarität des Eingangssignals die Schalteinrichtung in geeigneter Weise ansteuert.

Gemäß einem zweiten Aspekt der Erfindung wird ein Wandlersystem zum Melden und/oder zum Bekämpfen einer Gefahrensituation beschrieben, welche insbesondere in einem Gebäude auftreten können. Das Wandlersystem weist auf (a) eine Wandlervorrichtung, (b) ein Elektronikmodul zum Betreiben der Wandlervorrichtung und (c) eine Schnittstelle der oben beschriebenen Art.

Dem beschriebenen Wandlersystem liegt die Erkenntnis zugrunde, dass die oben erläuterte Schnittstelle automatisch einen polaritätsrichtigen Anschluss der Wandlervorrichtung gewährleistet, so dass beim elektrischen Anschließen der Wandlervorrichtung an eine zweipolige Leitung elektrische Montagefehler hinsichtlich der Polarität zuverlässig verhindert werden können.

Die Steuereinrichtung der Schnittstelle kann auch dem Elektronikmodul zugeordnet sein, so dass die Schnittstelle abgesehen von der Steuereinrichtung durch eine einfache elektronische Schaltung realisiert werden kann.

Zum Melden einer Gefahrensituation weist die Wandlervorrichtung einen Sensor, eine optische und/oder akustische Evakuiersteuerung bzw. Evakuierhilfe, eine optische und/oder eine akustische Anzeigeeinrichtung sein oder jedes andere Gerät sein, welches in einem Gefahrfall Personen beim Verlassen des Gefahrenbereichs unterstützt. Wie oben bereits erläutert, kommen als Sensoren beispielsweise Brand-, Rauch-, Temperatur-, Geruchs- und/oder chemische Detektoren in Betracht, welche abhängig von der jeweiligen Gefährdung eine Gefahrensituation erkennen können.

Zum Bekämpfen einer Gefahrensituation ist das beschriebene Wandlersystem dann geeignet, wenn die Wandlervorrichtung einen Aktuator bzw. ein Stellglied aufweist, mit dem die Gefahrensituation zumindest teilweise beseitigt werden kann. Im Falle eines Brandes kann die Wandlervorrichtung beispielsweise veranlassen, dass eine Tür automatisch geöffnet oder geschlossen wird oder dass andere geeignete Maßnahmen zur Brandbekämpfung, beispielsweise das Einschalten einer Sprinkleranlage, automatisch und zügig ergriffen werden.

Gemäß einem dritten Aspekt der Erfindung wird eine Wandleranlage zum Melden und/oder zum Bekämpfen einer Gefahrensituation beschrieben, welche insbesondere in einem Gebäude auftreten können. Die beschriebene Wandleranlage weist auf (a) ein Wandlersystem der oben beschriebenen Bauweise, (b) eine Zentrale, und (c) eine zweipolige Leitung, welche das Wandlersystem mit der Zentrale verbindet. Die Zentrale und das Wandlersystem sind derart ausgebildet, dass das Wandlersystem von der Zentrale mit elektrischer Energie versorgbar ist und dass von dem Wandlersystem Informationen über den Betriebszustand des Wandlersystems über die zweipolige Leitung an die Zentrale übertragbar sind.

Der beschriebenen Wandleranlage liegt die Erkenntnis zugrunde, dass das oben beschriebene Wandlersystem automatisch einen polaritätsrichtigen Anschluss der Wandlervorrichtung an der Zentrale gewährleistet. Auf diese Weise kann die Wandleranlage zum Melden und/oder zum Bekämpfen einer Gefahrensituation zuverlässig unter Vermeidung von elektrischen Montagefehlern in Betrieb genommen werden.

Gemäß einem Ausführungsbeispiel der Erfindung weist die Wandleranlage zusätzlich zumindest ein weiteres Wandlersystem der oben beschriebenen Bauweise auf, welches ebenfalls an der zweipoligen Leitung angeschlossen ist. Die verschiedenen Wandlersysteme können dabei auf die gleiche Art oder auf unterschiedliche Art und Weise an der Zentrale angeschlossen werden.
(A) Eine erste Anschlussart zeichnet sich dadurch aus, dass zumindest hinsichtlich des Anschlusses an den ersten Eingang eine korrekte Polarität in Bezug auf die Versorgungsspannung eingehalten werden muss. Beispielsweise muss gewährleistet werden, dass der erste Anschluss mit dem ersten Pol bzw. mit dem höheren elektrischen Potential der zweipoligen Leitung verbunden werden muss. Bei Verwendung der oben beschriebenen Gleichrichterelemente ist es dann unerheblich, ob der zweite Pol der zweipoligen Leitung mit dem niedrigeren Potential mit dem zweiten oder mit dem dritten Eingang verbunden wird. Die Schnittstelle wird automatisch den kontaktierten zweiten oder dritten Eingang mit dem zweiten Ausgang verbinden.
   Diese erste Anschlussart zeichnet sich zudem durch eine Trennfunktion aus, welche durch eine geeignete Ansteuerung der Schalteinrichtung realisiert wird, indem beide oder wenigstens eines der oben beschriebenen Schaltelemente der Schalteinrichtung geöffnet werden. Durch ein derartiges Öffnen der beiden Schaltelemente, oder wenigstens desjenigen mit dem Anschluss zu einem weiteren Wandlersystem direkt verbundenen Schaltelements, der Schnittstelle des Wandlersystems kann beispielsweise das weitere Wandlersystem, welches sich aus Sicht der Zentrale hinter dem Wandlersystem befindet, von der Zentrale getrennt werden. Dies ist insbesondere in dem Fall von Bedeutung, wenn die Leitung in dem Bereich zwischen dem Wandlersystem und dem weiteren Wandlersystem einen Kurzschluss aufweist.
   Ferner kann durch ein Schließen der beiden Schaltelemente eine niederohmige Verbindung zwischen dem zweiten und dem dritten Eingang hergestellt werden. Dadurch können Signale zum Zwecke der Signalisierung zu dem und/oder von dem weiteren Wandlersystem, welche Signale der Steuerung des weiteren Wandlersystems durch die Zentrale dienen oder welche Informationen über den Betriebszustand des weiteren Wandlersystems kodieren, ohne oder mit einer lediglich geringen Störung durch Wandlersystem über die zweipolige Leitung übertragen werden.
(B) Eine zweite Anschlussart zeichnet sich dadurch aus, dass beim Anschließen gewährleistet wird, dass weder der erste Pol noch der zweite Pol der zweipoligen Leitung mit dem ersten Eingang verbunden wird. Hinsichtlich der Polarität der elektrischen Verbindungen mit dem zweiten und dem dritten Eingang sind bei der Montage keine Besonderheiten zu beachten. Infolge der oben beschriebenen Gleichrichterelemente kann nämlich automatisch ein polaritätsrichtiger Anschluss gewährleistet werden.

An dieser Stelle wird ausdrücklich darauf hingewiesen, dass die beiden beschriebenen Anschlussarten innerhalb einer Wandleranlage kombiniert werden können. Dies bedeutet, dass zumindest ein Wandlersystem unter Verwendung der ersten Anschlussart (A) und zumindest ein weiteres Wandlersystem unter Verwendung der zweiten Anschlussart (B) an eine gemeinsame Zentrale angeschlossen werden können.

Weitere Vorteile und Merkmale der vorliegenden Erfindung ergeben sich aus der folgenden beispielhaften Beschreibung derzeit bevorzugter Ausführungsformen.

Figur 1 zeigt ein Grundschaltbild eines Gefahrenmelders, welcher eine Schnittstelle aufweist, die zwei unterschiedliche Anschlussarten an eine zweipolige Melderleitung erlaubt.

Figur 2a zeigt fünf Gefahrenmelder, welche gemäß einer ersten Anschlussart unter Beachtung der Polarität über eine Melderringleitung an eine Zentrale angeschlossen sind.

Figur 2b zeigt fünf Gefahrenmelder, welche gemäß einer zweiten Anschlussart ohne Beachtung der Polarität über eine Melderringleitung an eine Zentrale angeschlossen sind.

Figur 2c zeigt eine Mischinstallation von fünf Gefahrenmeldern, wobei drei Gefahrenmelder unter Beachtung der Polarität mit Ausfallsicherheit bei Unterbruch und Kurzschluss und zwei Gefahrenmelder polaritätsunabhängig ohne Ausfallschutz an eine Zentrale angeschlossen sind.

An dieser Stelle bleibt anzumerken, dass sich in der Zeichnung die Bezugszeichen von gleichen oder von einander entsprechenden Komponenten lediglich in ihrer ersten Ziffer und/oder durch einen angehängten Buchstaben unterscheiden.

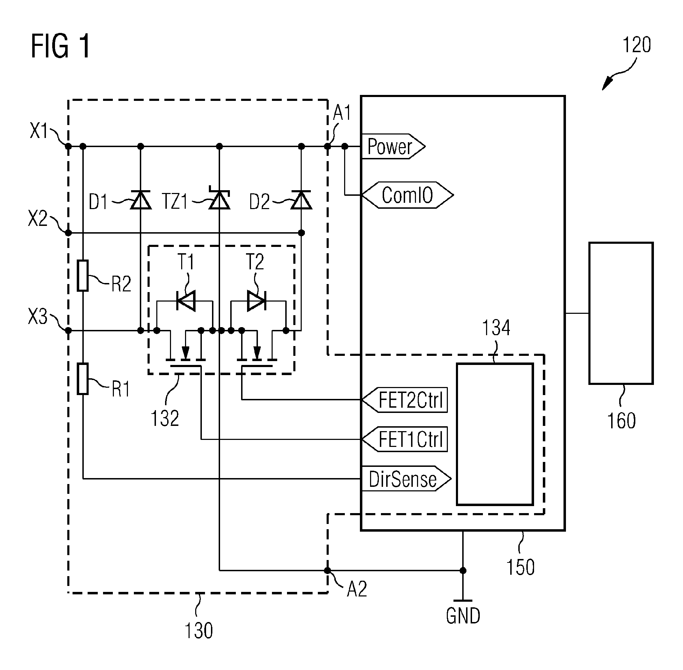

Figur 1 zeigt ein Grundschaltbild eines Gefahrenmelders 120, welcher eine Wandlervorrichtung 160 aufweist, die über eine Schnittstelle 130 an eine nicht dargestellte zweipolige Melderleitung anschließbar ist. Gemäß dem hier dargestellten Ausführungsbeispiel ist die Wandlervorrichtung eine Gefahrmeldeeinrichtung wie beispielsweise ein Brand-, Rauch-, Temperatur-, Geruchs- und/oder chemischer Detektor. Die Wandlervorrichtung kann jedoch auch ein Aktuator sein, welche in einem Gefahrenfall beispielsweise eine Tür öffnet oder eine Tür schließt. Die Wandlervorrichtung 160 weist ferner ein Elektronikmodul 150 auf, über das von der Melderleitung der Wandlervorrichtung 160 elektrische Energie zugeführt wird und/oder welches zu Kommunikation zwischen der Wandlervorrichtung 160 und einer in Figur 1 ebenfalls nicht dargestellten Zentrale verwendet wird.

Die Schnittstelle 130 weist drei Eingänge, einen ersten Eingang X1, einen zweiten Eingang X2 und einen dritten Eingang X3 auf. Die Schnittstelle 130 weist ferner zwei Ausgänge, einen ersten Ausgang A1 und einen zweiten Ausgang A2 auf. Der zweite Ausgang A2 stellt eine Erdung GND für den gesamten Gefahrenmelder 120 dar.

Der erste Ausgang A1 ist über eine direkte Drahtverbindung mit dem ersten Eingang X1 verbunden. Ferner ist der erste Ausgang A1 sowohl mit einem Spannungsversorgungseingang Power als auch mit einem Kommunikationseingang ComIO des Elektronikmoduls 150 verbunden. Wie nachfolgend genauer erläutert wird, ist der zweite Ausgang A2 mit dem zweiten Eingang X2 oder mit dem dritten Eingang X3 verbindbar.

Die Schnittstelle weist ferner eine Schalteinrichtung 132 auf, die ein erstes Schaltelement T1 und ein zweites Schaltelement T2 umfasst. Gemäß dem hier dargestellten Ausführungsbeispiel sind die beiden Schaltelemente T1 und T2 Feldeffekttransistoren. Die beiden Schaltelemente T1 und T2 sind jeweils über eine eigene Leitung mit einer Steuereinrichtung 134 verbunden. Mittels eines ersten Steuersignals FET1Ctrl kann das erste Schaltelement gezielt geöffnet bzw. geschlossen werden. Im geschlossenen Zustand des ersten Schaltelements T1 ist der zweite Ausgang A2 mit dem dritten Eingang X3 verbunden. Mittels eines zweiten Steuersignals FET2Ctrl kann das zweite Schaltelement gezielt geöffnet bzw. geschlossen werden. Im geschlossenen Zustand des zweiten Schaltelements T2 ist der zweite Ausgang A2 mit dem zweiten Eingang X2 verbunden.

Der Steuereinrichtung 134 wird ein Detektionssignal DirSense zugeführt, welches über zwei Widerstände, einen ersten Widerstand R1 und einen zweiten Widerstand R2 von den beiden Eingängen X2 und X3 abgegriffen wird. Wie nachfolgend noch erläutert wird, ist das Vorzeichen des Signals DirSense ein direkter Hinweis auf den elektrischen Anschluss der Schnittstelle 130.

Die Schnittstelle 130 weist ferner zwei als Dioden ausgebildete Gleichrichterelemente, eine erste Diode D1 und eine zweite Diode D2, auf. Diese Dioden D1 und D2 bilden zusammen mit den inhärenten Dioden der Transistoren T1 und T2 einen passiven Gleichrichter. Der Gleichrichter sorgt dafür, dass stets der erste Ausgang A1 mit dem positiven Pol der zweipoligen Leitung verbunden ist. In entsprechender Weise wird stets der der zweite Ausgang A2 mit dem negativen Pol der zweipoligen Leitung verbunden.

Zum Schutz der Schnittstelle 130 und/oder der Wandlervorrichtung 160 ist ferner eine Überspannungsschutzeinrichtung TZ1 vorgesehen, welche zwischen dem ersten Eingang X1 und dem dritten Eingang X3 geschaltet ist. Gemäß dem hier dargestellten Ausführungsbeispiel ist die Überspannungsschutzeinrichtung eine Zenerdiode TZ1.

Wie oben bereits angedeutet, kann der in Figur 1 dargestellte Gefahrenmelder 120 auf zwei grundlegend unterschiedliche Arten mit einer zweipoligen Meldeleitung verbunden werden. In beiden Fällen wird die Erdung bzw. die Gerätemasse niederohmig mit dem negativen Pol der Meldeleitung verbunden. Eine erste polaritätsabhängige Anschlussart (A) zeichnet sich dadurch aus, dass der erste Eingang X1 mit dem positiven Pol der Meldeleitung verbunden werden muss. Eine zweite polaritätsunabhängige Anschlussart (B) zeichnet sich dadurch aus, dass der erste Eingang X1 weder mit dem positiven noch mit dem negativen Pol der Meldelinie verbunden wird und somit unkontaktiert bleibt.
(A) Polaritätsabhängiger Anschluss des Gefahrenmelders 120 mit Trennfunktion für den Minusleiter über den stets positiven ersten Eingang X1 und die beiden Eingänge X2 und X3:
   Die inhärenten Dioden in den Transistoren T1 oder T2 ermöglichen einen Stromfluss zwischen der Erdung GND bzw. dem zweiten Ausgang A2 und dem mit dem negativen Pol der Melderleitung verbundenen Eingang X3 oder X2. Dadurch wird das Elektronikmodul 150 bei gesperrten Feldeffekttransistoren T1 und T2 über den Eingang X1 mit einer positiven Spannung gegenüber den Eingängen X2 oder X3 versorgt.
   Das Elektronikmodul 150 kann an dem Vorzeichen am Detektionssignal DirSense erkennen, ob der dritte Eingang X3 oder ob der zweite Eingang X2 mit dem negativen Potential der Melderleitung bzw. der Melderanschlussleitung verbunden ist. Falls der dritte Eingang X3 mit diesem negativen Potential verbunden ist, dann wird die Steuereinrichtung 134 über das erste Steuersignal FET1Ctrl den Transistor T1 schließen. Falls der zweite Eingang X2 mit diesem negativen Potential verbunden ist, dann wird die Steuereinrichtung 134 über das zweite Steuersignal FET2Ctrl den Transistor T2 schließen. Damit ist das Elektronikmodul 150 niederohmig mit dem Minus-Potential der Melderanschlussleitung verbunden.
   Die Aussagekraft des Signals DirSense in Bezug auf die Kontaktierung des Gefahrenmelders 120 ergibt sich aus folgender Überlegung:
      - Falls der dritte Eingang X3 mit dem negativen Potential der Melderleitung verbunden ist und der zweite Eingang X2 nicht kontaktiert oder mit einem Eingang eines nächsten Gefahrenmelders verbunden ist, dann ergibt sich bei jeweils geöffneten Transistoren T1 und T2 ein Stromfluss vom ersten Eingang X1 über den Anschluss A1 durch das Elektronikmodul 150 und über den Anschluss A2 und die inhärente Diode des Transistors T1 hin zu dem dritten Eingang X3. Der zweite Ausgang X2 bzw. die Erde GND wird sich dann einen bekannten Diodenpotentialabfall über dem dritten Eingang X3 befinden. Dies bedeutet, dass sich das Potential des dritten Eingangs und - über den Widerstand R1 - auch das Signal DirSense einen Diodenpotentialabfall unterhalb der Erde GND befinden. Der Steuereinrichtung 134, welche dem Elektronikmoduls 150 zugeordnet ist, wird folglich ein negatives Signal DirSense zugeführt.
      - Falls der zweite Eingang X2 mit dem negativen Potential der Melderleitung verbunden ist und der dritte Eingang X3 nicht kontaktiert oder mit einem Eingang eines nächsten Gefahrenmelders verbunden ist, dann ergibt sich bei jeweils geöffneten Transistoren T1 und T2 ein Stromfluss vom ersten Eingang X1 über den Anschluss A1 durch das Elektronikmodul 150 und über den Anschluss A2 und die inhärente Diode des Transistors T2 hin zum zweiten Eingang X2. Das Signal DirSense, welches über die beiden Widerstände R1 und R2 vom ersten Eingang X1 abgegriffen wird, wird damit nahe beim positiven Potential des ersten Eingangs X1 liegen. Der Steuereinrichtung 134 wird folglich ein positives Signal DirSense zugeführt.
   Zum Weiterschalten der Melderleitung zu einem nächsten Gefahrenmelder, welcher ebenfalls an die Melderleitung angeschlossen ist, kann die Steuereinrichtung 134 den noch offenen Transistor T2 oder T1 schließen. Für den Fall, dass der nächste Abschnitt der Melderleitung zwischen diesem Gefahrenmelder 120 und dem nächsten Gefahrenmelder kurzschlussbehaftet ist, dann kann durch erneutes Öffnen dieses Transistors der schadhafte Leitungsabschnitt durch eine Unterbrechung des Minus-Pols der Melderleitung abgetrennt werden.
(B) Polaritätsunabhängiger des Gefahrenmelders 120 ohne Trennfunktion für den Minusleiter über die Eingänge X2 und X3, der Eingang X1 wird nicht verwendet:
   Die Dioden D1 und D2 sowie die inhärenten Dioden der Feldeffekttransistoren T1 und T2 bilden bei gesperrten Transistoren T1 und T2 einen passiven Gleichrichter. Über diesen Gleichrichter wird das Elektronikmodul 150 mit einer positiven Spannung am Eingang Power gegenüber dem Masseanschluss GND gespeist.
   Wie oben bereits dargelegt, kann auch hier die Steuereinrichtung 134 am Vorzeichen des Detektionssignals DirSense erkennen, ob der dritte Eingang X3 mit dem positiven oder dem negativen Potential der Melderanschlussleitung verbunden ist. Ist der dritte Eingang X3 mit dem negativen Potential verbunden, dann wird die Steuereinrichtung 134 über das erste Steuersignal FET1Ctrl den Transistor T1 schließen. Ist der zweite Eingang X2 mit dem negativen Potential verbunden, dann wird die Steuereinrichtung 134 über das zweite Steuersignal FET2Ctrl den Transistor T2 schließen. Damit ist das Elektronikmodul 150 nun niederohmig mit dem Minus-Potential der Melderanschlussleitung verbunden.

Der in Figur 1 dargestellte Gefahrenmelder 120 mit drei Eingängen für eine zweipolige Melderleitung kann somit je nach Wahl der Anschlüsse an die Melderleitung als Kurzschlussisolator wirken oder die Melderlinie polaritätsrichtig mit dem Elektronikmodul 150 verbinden. Die Auswahl des geschlossenen Transistors T1 oder T2, der die polaritätskorrekte Verbindung der Melderlinie mit dem Elektronikmodul 150 sicherstellt, kann durch eine einfache Logikfunktion in dem Elektronikmodul 150 erfolgen, welche Logikfunktion die das Signal DirSense in geeigneter Weise auswertet. In beiden Anschaltvarianten stellt die Schnittstelle 130 die niederohmige Verbindung des Elektronikmoduls 150 mit einem der Bezugsleiter der Melderleitung sicher.

Gemäß dem hier dargestellten Ausführungsbeispiel wird die Erdung des Gefahrenmelders 120 mit dem Minuspotential der Melderleitung verbunden. Selbstverständlich können auch andere funktionsgleiche Schaltungen für die Verbindung mit dem Plusleiter verwendet werden.

Die niederohmige Verbindung zwischen der Erdung des Gefahrenmelders 120 und dem Minuspotential der Melderleitung hat den Vorteil, dass auch bei elektromagnetischen Einstrahlungen auf den Gefahrenmelder 120 bzw. die Melderleitung noch eine störungsfreie Kommunikation über die Melderleitung und den Kommunikationseingang ComIO erfolgen kann. Damit wird gewährleistet, dass die oft sehr sensitive Auswerteelektronik der Wandlervorrichtung 160 nicht stark verfälschte Resultate liefert.

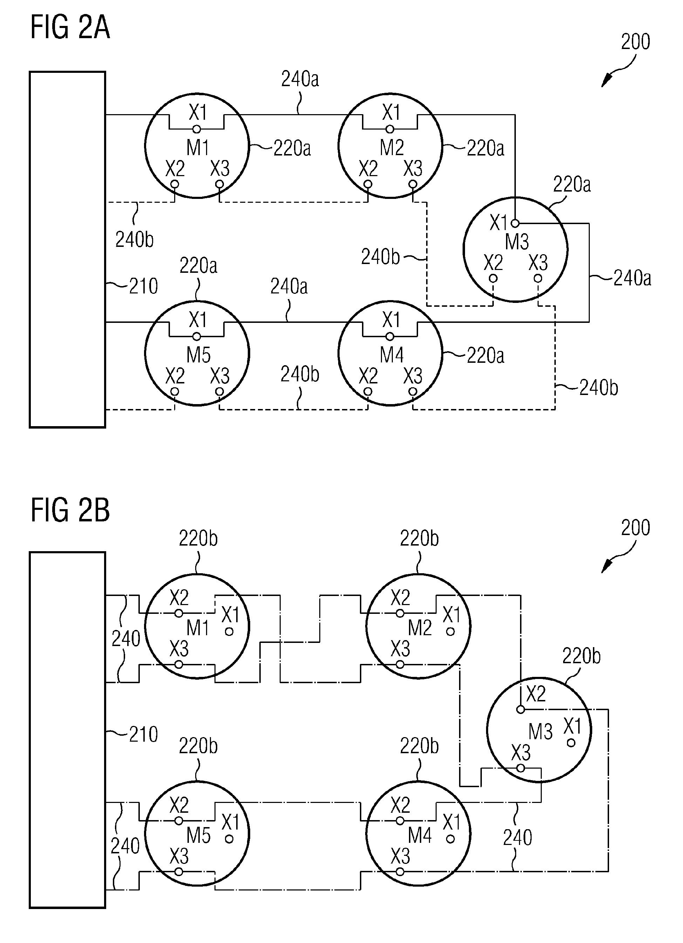

Figur 2a zeigt eine Wandleranlage 200, welche eine Zentrale 210, eine zweipolige Melderleitung mit einem Plusleiter 240a und einem Minusleiter 240b und fünf Gefahrenmelder 220a aufweist, welche gemäß der ersten polaritätsabhängigen Anschlussart (A) angeschlossen sind. Die Melderleitung ist eine bekannte Ringleitung, so dass bei einer unterbrechungs- und kurzschlussfreien Melderleitung jeder Gefahrenmelder 220a über zwei Pfade mit der Zentrale 210 verbunden ist. Die in Figur 2a dargestellte polaritätsabhängige Anschlussart (A) ermöglicht einen vollen Funktionserhalt bei einfachem Unterbruch- oder Kurzschlussfehler der Verdrahtung.

Figur 2b zeigt eine Wandleranlage 200, welche ebenfalls eine Zentrale 210, eine zweipolige Melderleitung 240 und fünf Gefahrenmelder 220b aufweist. Diese Gefahrenmelder 220b sind gemäß einer zweiten Anschlussart (B) ohne Beachtung der Polarität über die als Ringleitung ausgebildete Melderleitung 240 an die Zentrale 210 angeschlossen. Die in Figur 2b dargestellte polaritätsunabhängige Anschlussart (B) ermöglicht einen Funktionserhalt nur bei Unterbruchfehler. Ein Funktionserhalt bei einem Kurzschlussfehler in der Melderleitung ist nicht möglich. Dafür hat die in Figur 2b dargestellte Anschlussart den Vorteil, dass die Installation der gesamten Wandleranlage 200 ohne eine Beachtung der Polarität der Gefahrenmelder 220a erfolgen kann.

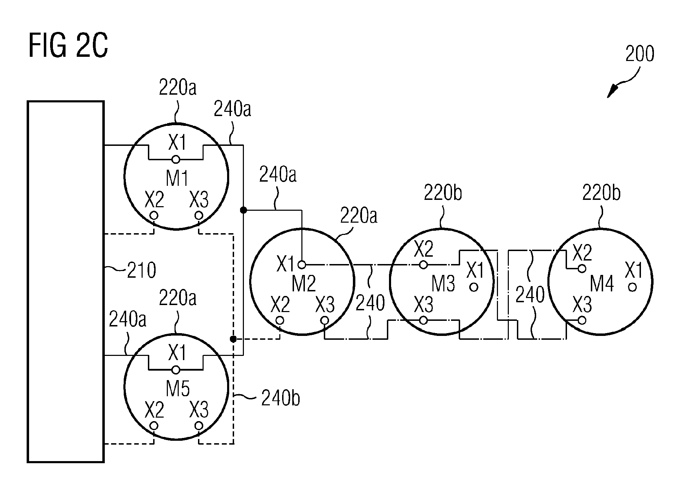

Figur 2c zeigt eine Wandleranlage 200 mit einer Zentrale 210, einer zweipolige Melderleitung 240 mit einem Plusleiter 240a und einem Minusleiter 240b und fünf Gefahrenmelder 220a bzw. 220b. Drei Gefahrenmelder 220a sind gemäß der ersten Anschlussart (A) unter Beachtung der Polarität mit Ausfallsicherheit in Bezug auf Unterbruch und Kurzschluss der Melderleitung angeschlossen. Zwei Gefahrenmelder 220b sind gemäß der zweiten Anschlussart (B) ohne Beachtung der Polarität angeschlossen. Diese in Figur 2c dargestellte gemischte Installationen ermöglicht einen vollem Funktionserhalt bei einfachem Leitungsfehler für die Gefahrenmelder 220a auf dem Ring der Melderleitung. Für die Gefahrenmelder 220b, welche ohne Beachtung der Polarität an dem Leitungsabgang von dem Ring der Melderleitung angeschlossen sind, kann ein Funktionserhalt nur bei Unterbruchfehler der Melderleitung gewährleistet werden.

Zusammenfassend bleibt festzustellen: Durch die mit dieser Anmeldung beschriebene Schnittstelle kann ein und derselbe Gefahrenmelder auf zwei unterschiedliche Anschlussarten mit einer zweipoligen Melderlinie verbunden werden. Gemäß einer ersten polaritätsabhängigen Anschlussart (A) kann ein Funktionserhalt auch bei Kurzschluss gewährleistet werden, wobei die Schnittstelle des Gefahrenmelders die Kurzschlusstrennfunktion bzw. die Kurzschlussisolatorfunktion übernimmt. Gemäß einer zweiten polaritätsunabhängigen Anschlussart (B) kann ein Funktionserhalt bei einem Kurzschluss in einem Abschnitt einer Melderleitung nicht gewährleistet werden. Auch bei Anwendungen, wo ein teilweiser Funktionserhalt bei Kurzschluss gefordert wird, kann ohne zusätzliche Kurzschlussisolatoren an jener Stelle der Melderleitung, an der eine Isolation möglich sein muss, der Gefahrenmelder nach dem Anschlussschema (A) mit Kurzschlussisolatorfunktion angeschlossen werden, alle übrigen Geräte können mit der polaritätsunabhängigen Anschlussart (B) verdrahtet werden.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 120: Wandlersystem / Gefahrenmelder
- 130: Schnittstelle
- 132: Schalteinrichtung
- 134: Steuereinrichtung
- X1: erster Eingang
- X2: zweiter Eingang
- X3: dritter Eingang
- A1: erster Ausgang
- A2: zweiter Ausgang
- D1: erstes Gleichrichterelement / erste Diode
- D2: zweites Gleichrichterelement / erste Diode
- T1: erstes Schaltelement / erster Transistor
- T2: zweites Schaltelement / zweiter Transistor
- TZ1: Überspannungsschutzeinrichtung / Zenerdiode
- R1: erster Widerstand
- R2: zweiter Widerstand
- GND: Erdung
- DirSense: Detektionssignal
- FET1Ctrl: erstes Steuersignal
- FET1Ctr2: zweites Steuersignal
- Power: Eingang Spannungsversorgung
- ComIO: Eingang Kommunikation
- 150: Elektronikmodul
- 160: Wandlervorrichtung

- 200: Wandleranlage
- 210: Zentrale
- 220a: Wandlersystem / Gefahrenmelder (erste Anschlussart)
- 220b: Wandlersystem / Gefahrenmelder (zweite Anschlussart)
- 240: zweipolige Leitung (Polarität unerheblich)
- 240a: Plusleiter
- 240b: Minusleiter

## Patentansprüche

1. Schnittstelle zum Anschließen einer Wandlervorrichtung (160) an eine zweipolige Leitung (240, 240a, 240b), wobei ein erster Pol (240a) ein höheres elektrisches Potential und der zweite Pol (240b) ein niedrigeres elektrisches Potential aufweist, die Schnittstelle (130) aufweisend
• einen ersten Eingang (X1),
• einen zweiten Eingang (X2),
• einen dritten Eingang (X3),
• einen ersten Ausgang (A1), welcher mit dem ersten Eingang (X1) verbunden ist,
• einen zweiten Ausgang (A2), welcher mit dem zweiten Eingang (X2) oder mit dem dritten Eingang (X3) verbindbar ist,
• eine Schalteinrichtung (132), welche mit dem zweiten Eingang (X2), mit dem dritten Eingang (X3) und mit dem zweiten Ausgang (A2) verbunden ist, und
• eine Steuereinrichtung (134),
- welche mit dem dritten Eingang (X3) derart gekoppelt ist, dass von dem dritten Eingang (X3) an die Steuereinrichtung (132) ein Detektionssignal (DirSense) zuführbar ist, welches indikativ ist, ob der zweite Eingang (X2) oder ob der dritte Eingang (X3) mit dem zweiten Pol (240b) der zweipoligen Leitung (240) verbunden ist, und
- welche mit der Schalteinrichtung (132) verbunden ist,
wobei
die Steuereinrichtung (134) derart eingerichtet ist, dass basierend auf dem Detektionssignal (DirSense) der zweite Eingang (X2) oder alternativ der dritte Eingang (X3) mit dem zweiten Ausgang (A2) verbunden wird.

2. Schnittstelle nach Anspruch 1, zusätzlich aufweisend
• ein erstes Gleichrichterelement (D1), welches zwischen dem dritten Eingang (X3) und dem ersten Ausgang (A1) geschaltet ist, und
• ein zweites Gleichrichterelement (D2), welches zwischen dem zweiten Eingang (X2) und dem ersten Ausgang (A1) geschaltet ist,
wobei
die beiden Gleichrichterelemente (D1, D2) derart orientiert sind, dass von dem zweiten Eingang (X2) und dem dritten Eingang (X3) derjenige Eingang (X2, X3), welcher mit dem ersten Pol (240a) der zweipoligen Leitung (240) verbunden ist, mit dem ersten Ausgang (A1) verbunden ist.

3. Schnittstelle nach einem der Ansprüche 1 bis 2, bei der die Schalteinrichtung (132) aufweist
• ein erstes Schaltelement (T1), welches zwischen dem dritten Eingang (X3) und dem zweiten Ausgang (A2) angeordnet ist, und
• ein zweites Schaltelement (T2), welches zwischen dem zweiten Eingang (X2) und dem zweiten Ausgang (A2) angeordnet ist.

4. Schnittstelle nach Anspruch 3, wobei die beiden Schaltelemente (T1, T2) unabhängig voneinander von der Steuereinrichtung (134) ansteuerbar sind.

5. Schnittstelle nach einem der Ansprüche 1 bis 4, zusätzlich aufweisend
• eine Überspannungsschutzeinrichtung (TZ1), welche zwischen dem ersten Ausgang (A1) und dem zweiten Ausgang (A2) geschaltet ist.

6. Schnittstelle nach einem der Ansprüche 1 bis 5, zusätzlich aufweisend
• einen ersten Widerstand (R1) zum Abgreifen des Detektionssignals (DirSense).

7. Schnittstelle nach Anspruch 6, zusätzlich aufweisend
• einen zweiten Widerstand (R2), welcher zwischen dem ersten Eingang (X1) und dem zweiten Eingang (X2) geschalten ist.

8. Wandlersystem zum Melden und/oder zum Bekämpfen einer Gefahrensituation, insbesondere in einem Gebäude, das Wandlersystem (120) aufweisend
• eine Wandlervorrichtung (160)
• ein Elektronikmodul (150) zum Betreiben der Wandlervorrichtung (160) und
• eine Schnittstelle (130) nach einem der Ansprüche 1 bis 7.

9. Wandleranlage zum Melden und/oder zum Bekämpfen einer Gefahrensituation, insbesondere in einem Gebäude, die Wandleranlage aufweisend
• ein Wandlersystem (120, 220a, 220b) nach Anspruch 8,
• eine Zentrale (210), und
• eine zweipolige Leitung (240), welche das Wandlersystem (120, 220a, 220b) mit der Zentrale (210) verbindet,
wobei
die Zentrale (210) und das Wandlersystem (120, 220a, 220b) derart ausgebildet sind, dass
- das Wandlersystem (120, 220a, 220b) von der Zentrale (210) mit elektrischer Energie versorgbar ist und dass
- von dem Wandlersystem (120, 220a, 220b) Informationen über den Betriebszustand des Wandlersystems (120, 220a, 220b) über die zweipolige Leitung (240, 240a, 240b) an die Zentrale (210) übertragbar sind.

10. Wandleranlage nach Anspruch 9, zusätzlich aufweisend
• zumindest ein weiteres Wandlersystem nach Anspruch 8, welches ebenfalls an der zweipoligen Leitung (240, 240a, 240b) angeschlossen ist.
